# EUROPEAN PATENT APPLICATION

(11) **EP 4 756 450 A1**
(43) Date of publication of application: **10.06.2026**
(21) Application number: 24913654.0
(22) Date of filing: 27.12.2024
(51) Int. Cl.: G01R 31/3828, G01R 31/396, G01R 19/30, G01R 19/165, H02J 7/00, H01M 10/48, H01M 10/052

(54) **APPARATUS AND METHOD FOR MANAGING BATTERY**

(30) Priority: 27.12.2023 KR 20230193123
(71) Applicant: LG Energy Solution, Ltd., Seoul 07335 (KR)
(72) Inventor: CHOI, Soon-Hyung, Daejeon 34122 (KR); KIM, Dae-Soo, Daejeon 34122 (KR); CHOI, Soon-Ju, Daejeon 34122 (KR); KIM, Young-Deok, Daejeon 34122 (KR)
(74) Representative: Goddar, Heinz J.
(86) International application number: PCT/KR2024/021240
(87) International publication number: WO 2025/143849

(57) **Abstract**

A battery management apparatus according to an embodiment of the present disclosure includes a measuring unit configured to measure voltage and current of a battery including a plurality of negative electrode active materials; a discharging unit having one end connected to a positive electrode terminal of the battery and the other end connected to a negative electrode terminal of the battery, and configured to discharge the battery; and a control unit configured to control the discharging unit to discharge the battery when the voltage of the battery corresponds to a preset reference voltage, and calculate a capacity of a target negative electrode active material among the plurality of negative electrode active materials of the battery based on a current measured in a discharge process.

## Description

### TECHNICAL FIELD

This application is based on and claims priority from Korean Patent Application No. 10-2023-0193123, filed on December 27, 2023, with the Korean Intellectual Property Office, the disclosure of which is incorporated herein in its entirety by reference.

The present disclosure relates to a battery management apparatus and method, and more particularly, to a battery management apparatus and method capable of predicting the lifespan of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, lifespan and safety improvement are also important. In order to improve battery safety, technology is required to accurately diagnose the current state of the battery.

### DISCLOSURE

### Technical Problem

The present disclosure is designed to solve the problems of the related art, and therefore the present disclosure is directed to providing a battery management apparatus and method capable of diagnosing the current state of a battery and further diagnosing the expected lifespan of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to one aspect of the present disclosure may comprise: a measuring unit configured to measure voltage and current of a battery including a plurality of negative electrode active materials; a discharging unit having one end connected to a positive electrode terminal of the battery and the other end connected to a negative electrode terminal of the battery, and configured to discharge the battery; and a control unit configured to control the discharging unit to discharge the battery when the voltage of the battery corresponds to a preset reference voltage, and calculate a capacity of a target negative electrode active material among the plurality of negative electrode active materials of the battery based on a current measured in a discharge process.

The control unit may be configured to calculate a discharge capacity of the battery by accumulating the current measured in the discharge process, and calculate the calculated discharge capacity as the capacity of the target negative electrode active material.

The control unit may be configured to set a discharge C-rate to be lower than or equal to a preset reference C-rate when the voltage of the battery corresponds to the reference voltage, and control the discharging unit so that the battery is discharged according to the set discharge C-rate.

The reference voltage may be preset as a voltage at which capacity expression of the target negative electrode active material begins in the discharge process.

The battery may be configured so that the capacity expression of the target negative electrode active material proceeds at a voltage lower than or equal to the reference voltage, and capacity expression of a non-target negative electrode active material proceeds at a voltage exceeding the reference voltage.

The reference voltage may be preset as a voltage of a peak corresponding to the target negative electrode active material in a differential profile, which represents a corresponding relationship between the voltage for the battery and a differential capacity for the voltage.

The control unit may be configured to determine a target profile corresponding to the capacity of the target negative electrode active material among a plurality of capacity retention profiles preset to correspond to a plurality of capacities, and predict a cycle-by-cycle lifespan of the battery based on the determined target profile.

The capacity retention profile may be configured to represent a corresponding relationship between a cycle and a capacity retention.

The control unit may be configured to predict the cycle-by-cycle lifespan of the battery based on a capacity of the target negative electrode active material calculated when the cycle of the battery is lower than or equal to a preset reference cycle.

A battery pack according to another aspect of the present disclosure may comprise the battery management apparatus according to an aspect of the present disclosure.

A vehicle according to still another aspect of the present disclosure may comprise the battery management apparatus according to an aspect of the present disclosure.

A battery management method according to still another aspect of the present disclosure may comprise: a voltage measuring step of measuring a voltage of a battery including a plurality of negative electrode active materials; a discharging step of discharging the battery when the voltage of the battery corresponds to a preset reference voltage; a current measuring step of measuring a current of the battery being discharged in the discharging step; and a capacity calculating step of calculating a capacity of a target negative electrode active material among the plurality of negative electrode active materials of the battery based on the current measured in the current measuring step.

### Advantageous Effects

According to one aspect of the present disclosure, the battery management apparatus has an advantage in that it may quickly diagnose the capacity of a target negative electrode active material among a plurality of active materials included in the battery by measuring the discharge capacity of the battery for a voltage section equal to or lower than a reference voltage.

In addition, according to one aspect of the present disclosure, the battery management apparatus has an advantage in that it may select batteries with serious defects at an early stage.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery management apparatus according to an embodiment of the present disclosure.
FIG. 2 is a schematic drawing showing a lithiation reaction of a negative electrode of a battery in a charge process.
FIG. 3 is a schematic drawing showing a lithiation reaction of a negative electrode of a battery in a discharge process.
FIG. 4 is a schematic drawing showing a battery profile according to an embodiment of the present disclosure.
FIG. 5 is a schematic drawing showing a differential profile according to an embodiment of the present disclosure.
FIG. 6 is a schematic drawing showing a plurality of capacity retention profiles according to an embodiment of the present disclosure.
FIG. 7 is a schematic drawing showing a battery pack according to another embodiment of the present disclosure.
FIG. 8 is a schematic drawing showing a vehicle according to still another embodiment of the present disclosure.
FIG. 9 is a diagram schematically showing a battery management method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

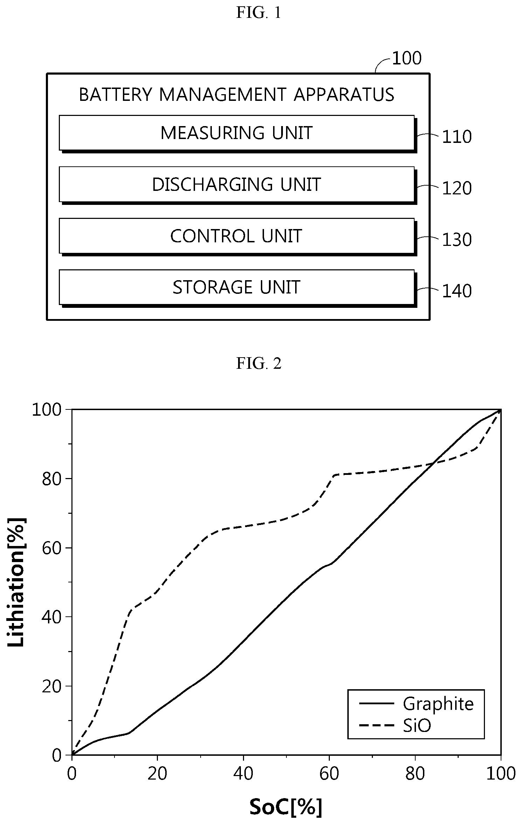

FIG. 1 is a diagram schematically showing a battery management apparatus 100 according to an embodiment of the present disclosure.

Referring to FIG. 1, the battery management apparatus 100 may include a measuring unit 110, a discharging unit 120 and a control unit 130.

Here, a battery means a physically separable independent cell including a negative electrode terminal and a positive electrode terminal. For example, a lithium-ion battery or a lithium polymer battery may be considered a battery. Additionally, the type of battery may be a cylindrical type, prismatic type, or pouch type. In addition, a battery may mean a battery bank, a battery module, or a battery pack in which a plurality of cells are connected in series and/or in parallel. Hereinafter, for convenience of explanation, a battery is described as meaning a single independent cell.

Additionally, the battery may include a plurality of different negative electrode active materials. For example, in the negative electrode of the battery, two or more types of negative electrode active materials may be blended. For example, the target negative electrode active material may be silicon (Si) and/or silicon oxide (SiOx), and the non-target negative electrode active material may be graphite.

And, at a voltage lower than or equal to a preset reference voltage, the capacity expression of the target negative electrode active material may proceed, and at a voltage higher than the reference voltage, the capacity expression of the non-target negative electrode active material may proceed. More specifically, when the battery is discharged, at a voltage higher than the reference voltage, the capacity expression of the non-target negative electrode active material may proceed, and at a voltage lower than or equal to the reference voltage, the capacity expression of the target negative electrode active material may proceed.

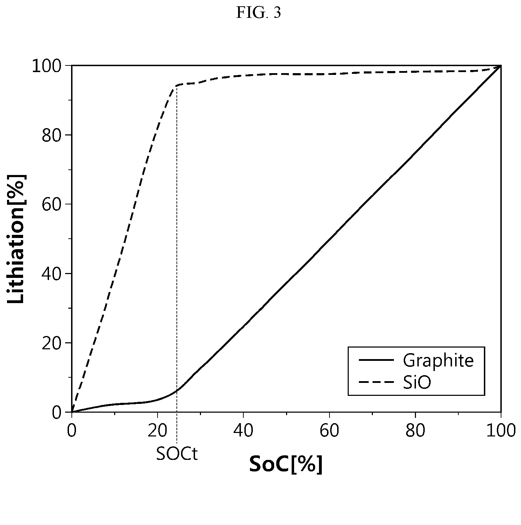

FIG. 2 is a schematic drawing showing a lithiation reaction of a negative electrode of a battery in a charge process. FIG. 3 is a schematic drawing showing a lithiation reaction of a negative electrode of a battery in a discharge process. Specifically, the battery according to the embodiments of FIGS. 2 and 3 includes a negative electrode in which 20% silicon (SiO) and 80% graphite are blended. And, the embodiments of FIGS. 2 and 3 are two-dimensional graphs in which the X-axis is set to the SOC (state of charge) of the battery and the Y-axis is set to the lithiation of silicon and graphite.

Referring to FIG. 2, in the charge process, lithiation of silicon and graphite proceeds competitively. However, referring to FIG. 3, in the discharge process, lithiation of graphite proceeds first and lithiation of silicon proceeds later. That is, in the discharge process, since the charge and discharge hysteresis of graphite and silicon are different, the capacity expressions of graphite and silicon do not proceed competitively. For example, in the embodiment of FIG. 3, the capacity expression of graphite starts at the beginning of the discharge, and the capacity expression of silicon starts when the SOC of the battery reaches the reference SOC (SOCr). Here, it should be noted that the capacity expression amount of silicon in the SOC section exceeding the reference SOC (SOCr) and the capacity expression amount of graphite in the SOC section lower than or equal to the reference SOC (SOCr) are very small and can be ignored.

Although the target negative electrode active material is described as silicon and/or silicon oxide above and the non-target negative electrode active material is described as graphite, it should be noted that the present disclosure may be applied without limitation to a battery including a plurality of active materials having different voltage sections in which the capacity is expressed.

The measuring unit 110 may be configured to measure voltage and current of a battery including a plurality of negative electrode active materials.

Specifically, the measuring unit 110 may be electrically connected to the positive electrode terminal and the negative electrode terminal of the battery. Then, the measuring unit 110 may measure the voltage of the battery by measuring the voltage across the two terminals of the battery.

In addition, the measuring unit 110 may be connected to a current measurement unit included in the charge and discharge path of the battery. The measuring unit 110 may measure the charge current and discharge current of the battery using the current measurement unit. Here, the charge and discharge path is a current path through which the charge and discharge current of the battery flows.

For example, the measuring unit 110 may measure the voltage of the battery according to a preset voltage measurement cycle. Also, the measuring unit 110 may measure the current of the battery according to a preset current measurement cycle. When diagnosing the state of the battery, since voltage and current are parameters that can be considered together, it is required that the voltage and current should be measured at the same or similar timing. Therefore, preferably, the voltage measurement cycle and the current measurement cycle may be set to be the same, and the voltage measurement time point and the current measurement time point may be set to be the same or within a predetermined time interval.

In addition, the measuring unit 110 may be connected to communicate with the control unit 130. For example, the measuring unit 110 may transmit information about the current and voltage of the measured battery to the control unit 130.

The discharging unit 120 may be configured such that one end is connected to a positive electrode terminal of the battery and the other end is connected to a negative electrode terminal of the battery.

Specifically, the discharging unit 120 may be electrically connected to the battery to form a closed circuit. For example, the discharging unit 120 may include a discharge resistor and a discharge switch that are connected in series with each other. In this case, the battery, the discharge resistor, and the discharge switch may be connected in series with each other to form a closed circuit.

The discharging unit 120 may be configured to discharge the battery.

Specifically, the operation state of the discharging unit 120 may be controlled by the control unit 130. More specifically, the operation state of the discharge switch included in the discharging unit 120 may be controlled by the control unit 130. For example, if the operation state of the discharge switch is controlled to a turn-on state by the control unit 130, the discharging unit 120 may discharge the battery. As another example, if the operation state of the discharge switch is controlled to a turn-off state by the control unit 130, the discharging unit 120 may not discharge the battery.

The control unit 130 may be configured to control the discharging unit 120 to discharge the battery when the voltage of the battery corresponds to a preset reference voltage (Vr).

Specifically, the control unit 130 may control the discharging unit 120 to discharge the battery when the voltage of the battery is equal to the preset reference voltage (Vr).

For example, for battery diagnosis, the battery may be charged or discharged until the voltage of the battery reaches the reference voltage (Vr). When the voltage of the battery reaches the reference voltage (Vr) through the charge or discharge, the control unit 130 may control the discharging unit 120 to discharge the battery.

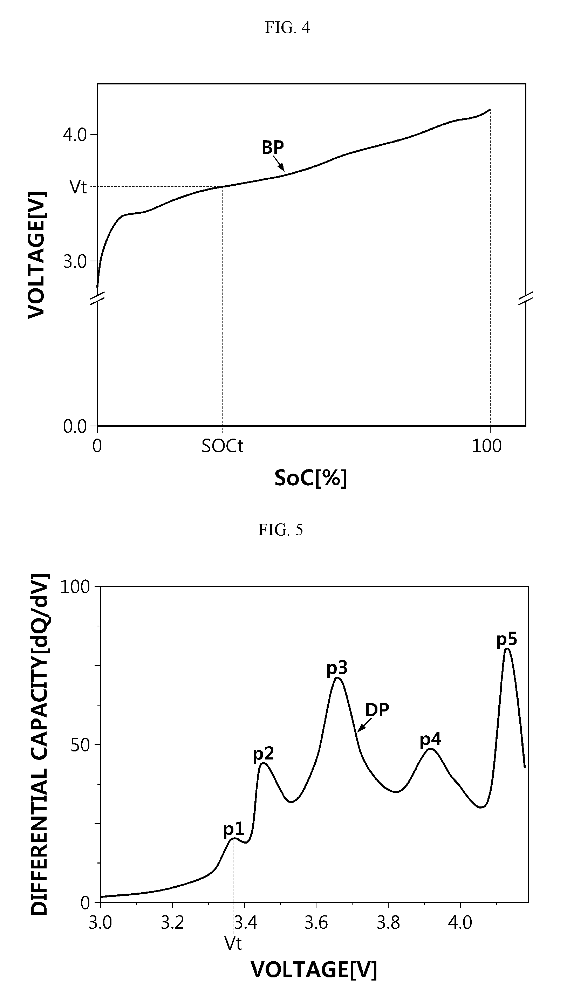

FIG. 4 is a schematic drawing showing a battery profile BP according to an embodiment of the present disclosure. The battery profile BP may be expressed as a two-dimensional graph in which the X-axis is set to the SOC of the battery and the Y-axis is set to the voltage of the battery. In addition, the battery profile BP of FIG. 4 is a profile for a battery including a negative electrode in which 20% silicon and 80% graphite are blended.

Specifically, the reference voltage (Vr) may be preset as a voltage at which the capacity expression of the target negative electrode active material starts in the discharge process.

For example, in the embodiment of FIG. 4, the capacity expression of graphite progresses in a voltage section exceeding the reference voltage (Vr), and the capacity expression of silicon progresses in a voltage section lower than or equal to the reference voltage (Vr). That is, silicon is a target negative electrode active material, and the reference voltage (Vr) may be preset as a voltage at which the capacity expression of silicon starts in the discharge process of the battery. That is, when the voltage of the battery reaches the reference voltage (Vr), the control unit 130 may control the discharging unit 120 to discharge the battery. Therefore, the capacity expression of silicon included in the battery may progress by the discharging unit 120.

The control unit 130 may be configured to calculate the capacity of the target negative electrode active material of the battery based on the current measured in the discharge process.

Specifically, the control unit 130 may be configured to calculate the discharge capacity of the battery by accumulating the current measured in the discharge process. More specifically, the control unit 130 may calculate the discharge capacity of the battery by accumulating the current measured after controlling the discharging unit 120.

For example, in the embodiment of FIG. 4, the control unit 130 may calculate the discharge capacity of the battery by accumulating the current measured until the voltage of the battery reaches a preset discharge termination voltage from the reference voltage (Vr).

And, the control unit 130 may be configured to calculate the calculated discharge capacity as the capacity of the target negative electrode active material.

Specifically, the reference voltage (Vr) may be preset as a voltage at which the capacity expression of the target negative electrode active material starts. Therefore, the discharge capacity based on the current measured in the voltage section lower than or equal to the reference voltage (Vr) may correspond to the capacity by the capacity expression of the target negative electrode active material. Therefore, the control unit 130 may determine the calculated discharge capacity as the capacity of the target negative electrode active material.

For example, in the embodiment of FIG. 4, the discharge capacity corresponding to the voltage section lower than or equal to the reference voltage (Vr) may be calculated as the capacity of silicon.

The battery management apparatus 100 according to an embodiment of the present disclosure has an advantage in that it may quickly diagnose the capacity of a target negative electrode active material among a plurality of active materials included in a battery by measuring the discharge capacity of the battery for a voltage section lower than or equal to a reference voltage (Vr).

Meanwhile, the control unit 130 provided in the battery management apparatus 100 may selectively include processors known in the art, application-specific integrated circuits (ASICs), other chipsets, logic circuits, registers, communication modems, data processing devices, and the like to execute various control logic performed in the present disclosure. Also, when the control logic is implemented in software, the control unit 130 may be implemented as a set of program modules. At this time, the program module may be stored in a memory and executed by the control unit 130. The memory may be located inside or out of the control unit 130 and may be connected to the control unit 130 by various well-known means.

In addition, the battery management apparatus 100 may further include a storage unit 140. The storage unit 140 may store data necessary for operation and function of each component of the battery management apparatus 100, data generated in the process of performing the operation or function, or the like. The storage unit 140 is not particularly limited in its type as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

The control unit 130 may be configured to set the discharge C-rate to be lower than or equal to a preset reference C-rate when the voltage of the battery corresponds to the reference voltage (Vr).

Specifically, the higher the discharge C-rate, the more noise may be included in the measured voltage and current. That is, the lower the discharge C-rate, the more accurate the measured discharge capacity is. Therefore, in order to more accurately calculate the capacity of the target negative electrode active material, the control unit 130 may set the discharge C-rate to be lower than or equal to a preset reference C-rate.

For example, the reference C-rate may be preset to 0.05 C. The control unit 130 may set the discharge C-rate to a C-rate lower than or equal to 0.05 C.

The control unit 130 may be configured to control the discharging unit 120 to discharge the battery according to the set discharge C-rate.

For example, assume that the discharge C-rate is set to 0.05 C. It takes about 20 hours to completely discharge the battery at a discharge C-rate of 0.05 C. However, the capacity expression of the target negative electrode active material does not proceed throughout the required time, but proceeds only in the voltage section lower than or equal to the reference voltage (Vr).

If the battery is discharged at a discharge C-rate lower than or equal to the reference C-rate when the voltage of the battery exceeds the reference voltage (Vr), it may take an unnecessarily long time to calculate the capacity of the target negative electrode active material. In addition, since the calculated discharge capacity includes both the capacity of the non-target negative electrode active material and the capacity of the target negative electrode active material, there is a problem that an additional procedure is required to separate the calculated discharge capacity into the capacity of the target negative electrode active material and the capacity of the non-target negative electrode active material.

On the other hand, if the battery is discharged at a discharge C-rate lower than or equal to the reference C-rate from the time when the voltage of the battery corresponds to the reference voltage (Vr), the time required for discharging may be drastically reduced compared to completely discharging the battery. In addition, since the discharge capacity of the battery corresponds to the capacity of the target negative electrode active material, the additional procedure described above is not required. Therefore, the capacity of the target negative electrode active material may be quickly calculated.

The battery management apparatus 100 may accurately and quickly calculate the discharge capacity according to the capacity expression of the target negative electrode active material by setting the discharge C-rate to be lower than or equal to the reference C-rate when the voltage of the battery corresponds to the reference voltage (Vr).

The reference voltage (Vr) may be preset as the voltage of a peak corresponding to the target negative electrode active material in a differential profile DP, which represents the corresponding relationship between the voltage for the battery and the differential capacity for the voltage.

Specifically, the differential profile DP may be a profile that differentiates the battery profile BP with respect to voltage. That is, the differential profile DP may be a profile that represents the corresponding relationship between the voltage (V) and the differential capacity (dQ/dV). Here, the differential capacity means a value that differentiates the capacity with respect to voltage.

The differential profile DP may include one or more peaks. Here, the peak is a point corresponding to an inflection point of the battery profile BP. Specifically, the peak is a point that has an upward convex shape and where the rate of change of the differential capacity with respect to the voltage is 0. That is, the instantaneous rate of change (the slope of the differential capacity with respect to the voltage) on the low voltage side based on the peak is positive, and the instantaneous rate of change on the high voltage side is negative.

The peak is an important factor indicating the state of the battery. For example, peaks indicating the negative electrode state and positive electrode state of the battery may each be included in the differential profile DP. In addition, if the battery includes a plurality of active materials, peaks corresponding to each active material may be included in the differential profile DP.

Based on the hysteresis difference of the plurality of active materials, the capacity expressions of the target negative electrode active material and the non-target negative electrode active material alternately progress with respect to the reference voltage (Vr). Since the alternate progress of the capacity expressions of the target negative electrode active material and the non-target negative electrode active material greatly affects the state of the battery, the differential profile DP may include a peak corresponding to the reference voltage (Vr). In other words, the voltage of the peak corresponding to the target negative electrode active material among the plurality of peaks included in the differential profile DP may be preset as the reference voltage (Vr).

FIG. 5 is a schematic drawing showing a differential profile DP according to an embodiment of the present disclosure. Specifically, the differential profile DP of FIG. 5 is a profile in which the X-axis is set to voltage and the Y-axis is set to differential capacity. The differential profile DP includes a first peak p1, a second peak p2, a third peak p3, a fourth peak p4, and a fifth peak p5. Here, based on a 4.2 V battery, the first peak p1, which appears at about 3.4 V or below, is known to be a peak corresponding to silicon. That is, when the battery is discharged, the capacity expression of silicon progresses from Vt, which is the voltage of the first peak p1. Therefore, the voltage that serves as a reference for calculating the capacity of silicon may be preset as the voltage of the first peak p1.

The control unit 130 may be configured to determine a target profile corresponding to the capacity of the target negative electrode active material among a plurality of capacity retention profiles preset to correspond to a plurality of capacities.

Specifically, the capacity retention profile may be configured to represent a corresponding relationship between cycles and capacity retention. Here, the capacity retention is a value representing the ratio of the maximum capacity to the design capacity of the battery. For example, the capacity retention decreases as the cycle degradation degree increases or the calendar degradation degree increases.

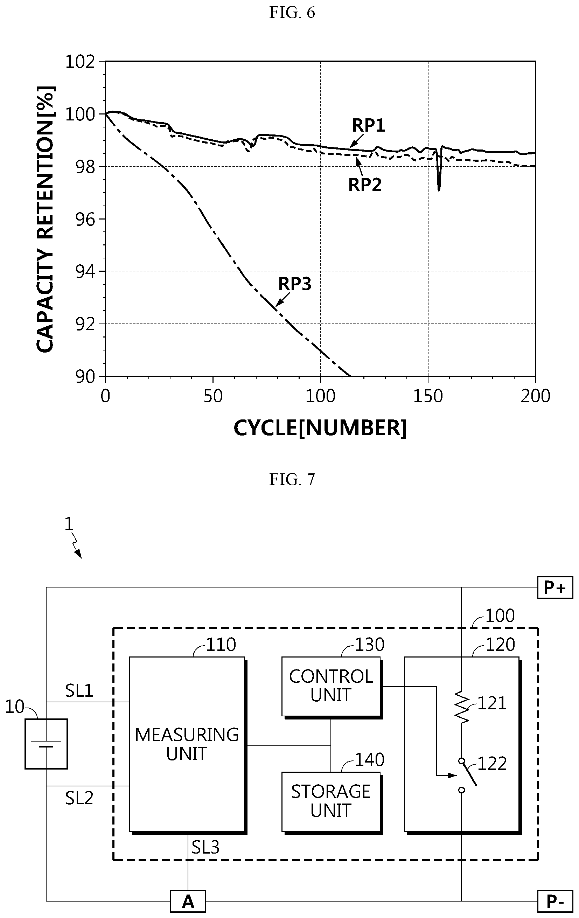

FIG. 6 is a schematic drawing showing a plurality of capacity retention profiles according to an embodiment of the present disclosure.

FIG. 6 includes a first capacity retention profile RP1, a second capacity retention profile RP2, and a third capacity retention profile RP3. The first capacity retention profile RP1 is a profile for a preset first battery, the second capacity retention profile RP2 is a profile for a preset second battery, and the third capacity retention profile RP3 is a profile for a preset third battery. Specifically, each of the first to third capacity retention profiles RP3 is a profile that records capacity retention per cycle while charging and discharging the corresponding battery at a 1 C-rate for a voltage section of 2.5 V to 4.2 V.

Here, the first to third batteries are all batteries including a negative electrode in which 20% silicon and 80% graphite are blended. And, based on the BOL (Beginning of life) state, the silicon capacity of the first battery is the largest, and the silicon capacity of the third battery is the smallest. For example, the silicon capacity of the first battery is 1.53 Ah, the silicon capacity of the second battery is 1.51 Ah, and the silicon capacity of the third battery is 0.67 Ah.

The control unit 130 may be configured to predict the cycle-by-cycle lifespan of the battery based on the determined target profile.

Preferably, the control unit 130 may be configured to predict the cycle-by-cycle lifespan of the battery based on the capacity of the target negative electrode active material calculated when the cycle of the battery is less than or equal to a preset reference cycle.

The reference cycle may be the maximum cycle that can be judged as a BOL state. For example, the reference cycle may be preset to the 10th cycle.

That is, the control unit 130 may calculate the initial capacity of the target negative electrode active material of the battery and determine a target profile corresponding to the calculated initial capacity from a plurality of preset capacity retention profiles. In addition, the control unit 130 may predict the cycle-by-cycle lifespan of the battery based on the determined target profile.

For example, if the capacity of the target negative electrode active material of the battery is calculated as 0.67 Ah, the cycle-by-cycle lifespan of the battery may follow the third capacity retention profile RP3. In this case, the control unit 130 may predict the cycle-by-cycle lifespan in advance based on the third capacity retention profile RP3. For example, the control unit 130 may predict the lifespan of the battery at about 110 cycles to be about 90%.

The battery management apparatus 100 has an advantage in that it may predict the cycle-by-cycle lifespan of a battery based on the capacity of the target negative electrode active material calculated at the beginning of the battery cycle. That is, since the cycle-by-cycle lifespan of a battery may be predicted based on the capacity of the initial target negative electrode active material, batteries with a high possibility of sudden death, etc. may be screened out more easily. Therefore, the battery management apparatus 100 has an advantage in that it may screen out batteries with serious defects early.

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the components included in the conventional BMS. For example, the measuring unit, the discharging unit, the control unit, and the storage unit of the battery management apparatus 100 may be implemented as components of the BMS.

In addition, the battery management apparatus 100 according to the present disclosure may be provided in a battery pack. That is, the battery pack according to the present disclosure may include the above-described battery management apparatus 100 and one or more battery cells. In addition, the battery pack may further include electrical equipment (relays, fuses, etc.) and a case.

FIG. 7 is a schematic diagram showing a battery pack according to another embodiment of the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

A measuring unit 110 may be connected to a first sensing line SL1, a second sensing line SL2, and a third sensing line SL3. Specifically, the measuring unit 110 may be connected to a positive electrode terminal of the battery 10 through the first sensing line SL1, and may be connected to a negative electrode terminal of the battery 10 through the second sensing line SL2. The measuring unit 110 may measure the voltage of the battery 10 based on the voltage measured at each of the first sensing line SL1 and the second sensing line SL2.

In addition, the measuring unit 110 may be connected to an ampere meter A through the third sensing line SL3. For example, the ampere meter A may be an ammeter or a shunt resistor capable of measuring the charging current and the discharging current of the battery 10. The measuring unit 110 may calculate the charge amount by measuring the charging current of the battery 10 through the third sensing line SL3. Also, the measuring unit 110 may calculate the discharge amount by measuring the discharge current of the battery 10 through the third sensing line SL3.

The discharging unit 120 may have one end connected to a positive electrode terminal of the battery 10 and the other end connected to a negative electrode terminal of the battery 10. In addition, the discharging unit 120 may be operated under the control of the control unit 130. For example, the discharging unit 120 may discharge the battery 10 when it receives a discharge command (or a discharge command signal) from the control unit 130.

For example, the discharging unit 120 may include a discharge resistor 121 and a discharge switch 122. In addition, the control unit 130 may control the discharging unit 120 to discharge the battery 10 by controlling the operation state of the discharge switch 122.

An external device may be connected to the positive electrode terminal P+ and negative electrode terminal P- of the battery pack 1. For example, the external device may be a charge and discharge device or a load.

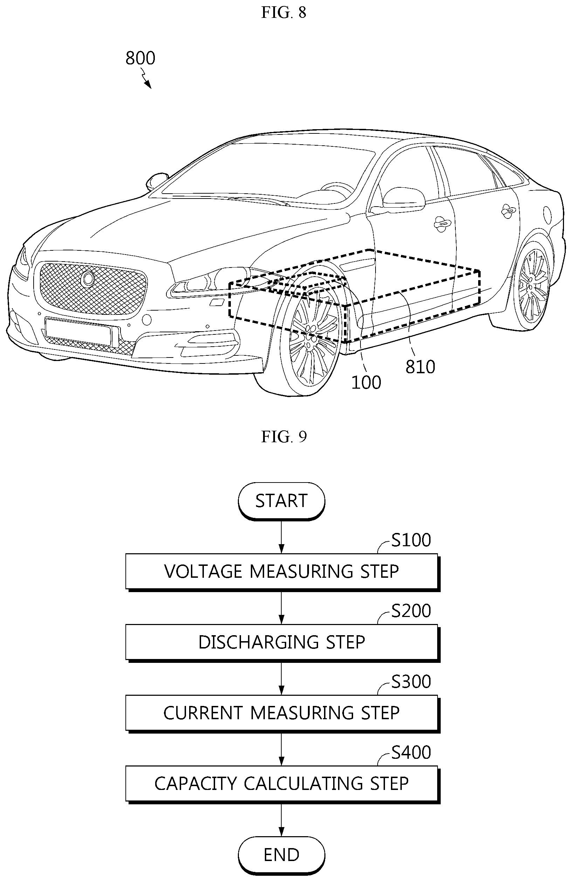

FIG. 8 is a schematic drawing showing a vehicle 800 according to still another embodiment of the present disclosure.

Referring to FIG. 8, the battery pack according to an embodiment of the present disclosure may be included in a vehicle 800, such as an electric vehicle (EV) or a hybrid vehicle (HV). In addition, the battery pack 810 may drive the vehicle 800 by supplying power to a motor through an inverter provided in the vehicle 800. Here, the battery pack 810 may include the battery management apparatus 100. That is, the vehicle 800 may include the battery management apparatus 100. In this case, the battery management apparatus 100 may be an onboard diagnostic device included in the vehicle 800.

FIG. 9 is a diagram schematically showing a battery management method according to still another embodiment of the present disclosure.

Preferably, each step of the battery management method may be performed by the battery management apparatus 100. Hereinafter, for convenience of explanation, contents overlapping with the previously described contents will be omitted or briefly described.

Referring to FIG. 9, the battery management method may include a voltage measuring step (S100), a discharging step (S200), a current measuring step (S300) and a capacity calculating step (S400).

The voltage measuring step (S100) is a step of measuring a voltage of a battery including a plurality of negative electrode active materials, and may be performed by the measuring unit 110.

The discharging step (S200) is a step of discharging the battery when the voltage of the battery corresponds to a preset reference voltage (Vr), and may be performed by the discharging unit 120.

Specifically, the reference voltage (Vr) may be preset as a voltage at which the capacity expression of the target negative electrode active material starts in the discharge process. The control unit 130 may control the discharging unit 120 to discharge the battery when the voltage of the battery reaches the reference voltage (Vr).

The current measuring step (S300) is a step for measuring a current of the battery discharged in the discharging step (S200), and may be performed by the measuring unit 110.

For example, the measuring unit 110 may measure the discharge current of the battery when the discharging unit 120 discharges the battery under the control of the control unit 130.

The capacity calculating step (S400) is a step of calculating a capacity of a target negative electrode active material among a plurality of negative electrode active materials of the battery based on the current measured in the current measuring step (S300), and may be performed by the control unit 130.

Specifically, the control unit 130 may calculate the capacity of the target negative electrode active material of the battery by accumulating the discharge current of the battery measured by the measuring unit 110. That is, in a voltage section lower than or equal to the reference voltage (Vr), the capacity expression of the target negative electrode active material progresses, and the capacity expression of the non-target negative electrode active material does not progress or is at a level that can be ignored. Therefore, the control unit 130 may determine the calculated capacity of the battery as the capacity of the target negative electrode active material.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

1: battery pack
10: battery
100: battery management apparatus
110: measuring unit
120: discharging unit
130: control unit
140: storage unit
800: vehicle
810: battery pack

## Claims

1. A battery management apparatus, comprising:
a measuring unit configured to measure voltage and current of a battery including a plurality of negative electrode active materials;
a discharging unit having one end connected to a positive electrode terminal of the battery and the other end connected to a negative electrode terminal of the battery, and configured to discharge the battery; and
a control unit configured to control the discharging unit to discharge the battery when the voltage of the battery corresponds to a preset reference voltage, and calculate a capacity of a target negative electrode active material among the plurality of negative electrode active materials of the battery based on a current measured in a discharge process.

2. The battery management apparatus according to claim 1,
wherein the control unit is configured to calculate a discharge capacity of the battery by accumulating the current measured in the discharge process, and calculate the calculated discharge capacity as the capacity of the target negative electrode active material.

3. The battery management apparatus according to claim 1,
wherein the control unit is configured to set a discharge C-rate to be lower than or equal to a preset reference C-rate when the voltage of the battery corresponds to the reference voltage, and control the discharging unit so that the battery is discharged according to the set discharge C-rate.

4. The battery management apparatus according to claim 1,
wherein the reference voltage is preset as a voltage at which capacity expression of the target negative electrode active material begins in the discharge process.

5. The battery management apparatus according to claim 4,
wherein the battery is configured so that the capacity expression of the target negative electrode active material proceeds at a voltage lower than or equal to the reference voltage, and capacity expression of a non-target negative electrode active material proceeds at a voltage exceeding the reference voltage.

6. The battery management apparatus according to claim 1,
wherein the reference voltage is preset as a voltage of a peak corresponding to the target negative electrode active material in a differential profile, which represents a corresponding relationship between the voltage for the battery and a differential capacity for the voltage.

7. The battery management apparatus according to claim 1,
wherein the control unit is configured to determine a target profile corresponding to the capacity of the target negative electrode active material among a plurality of capacity retention profiles preset to correspond to a plurality of capacities, and predict a cycle-by-cycle lifespan of the battery based on the determined target profile, and
wherein the capacity retention profile is configured to represent a corresponding relationship between a cycle and a capacity retention.

8. The battery management apparatus according to claim 7,
wherein the control unit is configured to predict the cycle-by-cycle lifespan of the battery based on a capacity of the target negative electrode active material calculated when the cycle of the battery is lower than or equal to a preset reference cycle.

9. A battery pack, comprising the battery management apparatus according to any one of claims 1 to 8.

10. A vehicle, comprising the battery management apparatus according to any one of claims 1 to 8.

11. A battery management method, comprising:
a voltage measuring step of measuring a voltage of a battery including a plurality of negative electrode active materials;
a discharging step of discharging the battery when the voltage of the battery corresponds to a preset reference voltage;
a current measuring step of measuring a current of the battery being discharged in the discharging step; and
a capacity calculating step of calculating a capacity of a target negative electrode active material among the plurality of negative electrode active materials of the battery based on the current measured in the current measuring step.
